# EUROPEAN PATENT APPLICATION

(11) **EP 2 073 277 A1**
(43) Date of publication of application: **24.06.2009**
(21) Application number: 07301704.8
(22) Date of filing: 19.12.2007
(51) Int. Cl.: H01L 31/0304, H01L 31/107

(54) **Avalanche photodiode**

(71) Applicant: Alcatel Lucent, 75008 Paris (FR)
(72) Inventor: Achouche, Mohand, 92120, MONTROUGE (FR); Decobert, Jean, 91620, NOZAY (FR)
(74) Representative: Shamsaei Far, Hassan

(57) **Abstract**

A method of manufacturing a planar junction, separate absorption, grading and multiplication avalanche photodiode, and the photodiode produced by said method. The photodiode comprises an absorption layer (6), a multiplication layer (3) and a charge layer (4) doped with Carbon and an N-type window layer (7) doped with a P-type dopant which is in contact with a bias electrode (10) to which bias voltage is applied so as to generate an electric field in the photodiode. The doping of the window layer with a P-type dopant is performed by local diffusion of dopant atoms within a limited volume of the window layer adjacent and underneath the bias electrode such that the window layer is substantially free of dopant atoms outside said limited volume.

## Description

The present invention relates to the field of Avalanche Photodiodes (APD). In particular the invention relates to APDs of the type known as Separate Absorption Grading and Multiplication (SAGM). This type of diodes are usually used in optical communications as well as in ranging, sensing, spectroscopy application.

### BACKGROUND O F THE INVENTION

APDs are photodetector semiconductor devices structured by means of a number of layers. The structure is usually made by epitaxial growth of layers of semiconductor material. One of such layers is the so-called absorption layer where the energy of incident photons is absorbed so as to cause a transition between energy levels of an atom. By the absorption of its energy, the photon is eliminated and the absorbed energy gives rise to the generation of charge carriers.

Another layer in an APD is the multiplication, or avalanche, layer. In this layer, charge carriers generated in the absorption layer are subject to an electric field causing their acceleration to a relatively high speed. The accelerated charge carriers, for example electrons or holes, then strike atoms and cause electrons from the atoms to break loose and become free to move. The process of acceleration and striking atoms continues as more electrons become free, thus striking more atoms. This causes an exponential increase in the number of free charge carriers which is referred to as "multiplication" or "avalanche". The multiplication of charge carriers provides the possibility of obtaining a substantial gain in the device which in turn improves the sensitivity of the device.

Both multiplication and absorption layers are known in the related art.

However, the avalanche effect needs to be controlled in order to avoid saturation or break down in the APD. This is done by controlling the electric field across the APD such that the electric filed in the absorption layer is substantially lower than that in the multiplication layer. In order to achieve this objective, an intermediate layer is used which serves as an isolation screen between the two aforementioned layers. The isolation screen is usually called the charge control layer or simply the charge layer. The charge layer is usually surrounded by bandgap transition layers between absorption layer and multiplication layer.

APDs made of InP/InGaAs (indium-Phosphide/Indium-Gallium-Arsenide) have the disadvantage of having a limited gain-bandwidth product typically being lower than 80 GHz. In optical telecommunications, these diodes are mainly used for applications limited to bit rates in the range of 2,5 to 10 Gbit/s. For applications of higher speed APDs of the type SAGM, and based on InAlAs/InGaAs (Indium-Aluminum-Arsenide/Indium-Gallium-Arsenide) material are preferred. These latter diodes have a higher rate of ionization coefficients as regard electrons and holes as compared to those of APDs based on InP/InGaAs. By using the SAGM, InAlAs/InGaAs it becomes possible to obtain a better gain-bandwidth product with less excess noise.

For a high performance APD, i.e. operating at large gain and high bit rate of about 10 Gbits/s or higher, it is also important that the electric field is as low as possible in the vicinity of the junction of the device in order to minimize leakage currents and ensure long term device stability.

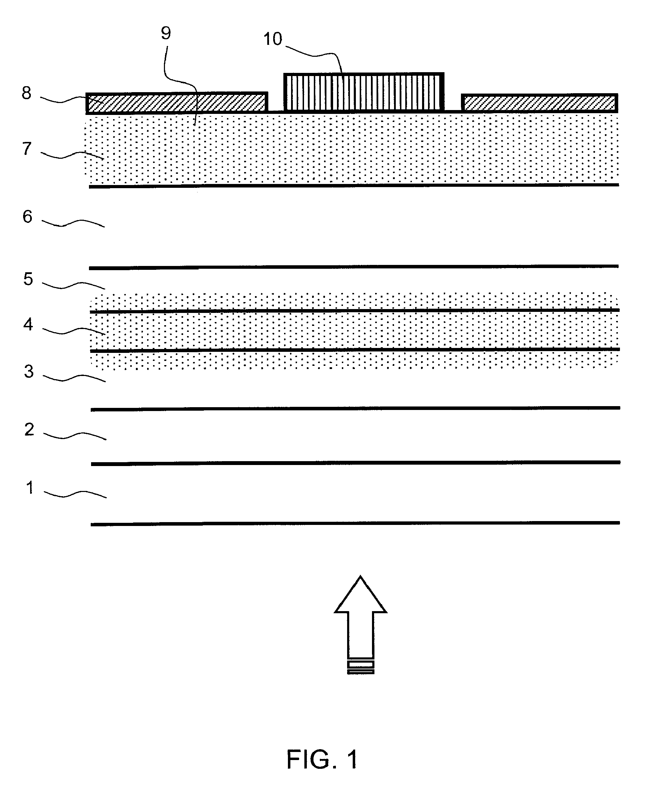

Figure 1 shows a schematic cross section view of a diode having SAGM, InAlAs/InGaAs structure in a conventional configuration where light is incident from the lower part of the device as shown by an arrow in the figure. This is only exemplary, as light may also be incident to the upper side of the device. Starting from the bottom to the top of the device, in the direction of the entry of photon, the APD of figure 1 comprises:
- a substrate 1, typically made of InP,
- a contact layer 2, usually being N-type and typically of InAlAs material,
- a multiplication layer 3 typically being of non-intentionally doped InAIAs material
- a charge layer 4 typically of InAlAs material P-doped with Zinc or Beryllium atoms,
- a grading layer 5 typically of InGaAlAs material having a compositional structure of a gradual profile which varies in bandgap value from one side of the layer to another in the direction of the passage of the charge carriers in order to facilitate this passage between the charge layer 4 and the absorption layer 6,
- an absorption layer 6 typically of non-doped InGaAs material,
- a contact layer 7 typically of InP material doped with P-type atoms 9.

The device is then covered with a protection layer 8 also known as "passivation" layer made of dielectric SiNx or SiOx, and a bias electrode 10.

The doping of the P-type zone 9 within the contact layer 7 is usually done by diffusion of Zinc at high temperatures, typically about or over 500°C. This process at such high temperatures usually induces, in the charge layer 4, a lateral expansion, or out-diffusion, of the Zinc or Beryllium atoms which is due to the high level of diffusivity of these atoms especially having regard to their level of concentration of about 10¹² dopants per cm². In figure 1, the dopant atoms are shown by means of a dotted area in and on the sides of the charge layer 4. As see in the figure, the out-diffusion of these atoms is represented by means of dotted areas which have expanded beyond the charge layer 4 into the multiplication layer 3 and the grading layer 5.

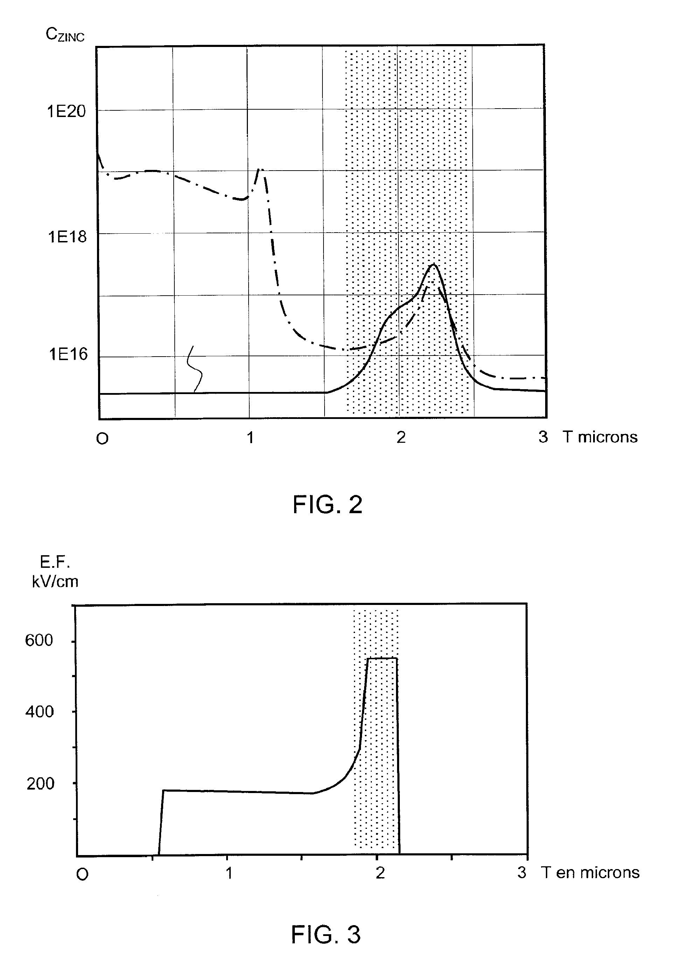

This effect is shown in figure 2 in which Zinc is used as dopant material of the charge layer of the APD. In the figure, the Zinc concentration C_{ZINC} in number of atoms per cm³ is shown as a function of thickness T in microns. The solid line curve shows the concentration before the diffusion of the dopant in the contact layer 7 and the broken line shown this concentration after such diffusion at a temperature of about 500° C.

The measurements are made by the technique known as Secondary Ion Mass Spectrometry (SIMS). In figure 2, the charge layer zone is represented by a dotted zone. It is observed from the figure that the concentration of the Zinc extends substantially beyond the charge layer after the dopant diffusion is done in the contact layer.

This effect has as a consequence, a substantial increase in the electric field in the absorption layer which is undesirable. Figure 3 represents this consequence. In this figure, the variation of the electric field E.F. is shown in kV/cm as a function of thickness T in microns. The multiplication layer is shown by a dotted zone. It is observed that the electric field in the multiplication layer is less than three times the electric field in the absorption layer, whereas if the concentration of the Zinc atoms in the charge layer been controlled so as to avoid out-diffusion, the electric field in the multiplication layer would have been six times larger than that of the absorption layer.

The out-diffusion effect leads to very poor APD characteristics. Some of such poor characteristics are for example low maximum multiplication gain, low gain-bandwidth product, or large dark current generating additional shot noise.

Another problem which has a negative effect on the electric field control, which in particular is significant in Mesa-type APDs, is due to the fact that during epitaxial growth of the layers on the device, the dopant atoms of the contact layer of the APD - made of P-doped InP layer- are uniformly distributed throughout the whole volume of this layer. This is schematically shown in figure 1 by means of the dotted area 9. As a result, an electric filed applied to such a device is distributed along the P-contact layer up to the device edge (Mesa-edge) thus giving rise to an undesired side current, which is referred to as surface leakage current. The surface leakage current becomes particularly problematic at high bit rate performances such as at 10Gbits/s and above because it has a negative impact on maximum available gain and breakdown voltage.

### DESCRIPTION OF THE INVENTION

The present invention provides a solution to overcome the above identified drawbacks. In particular the present invention provides a method for manufacturing an avalanche photodiode and an avalanche photodiode manufactured using said method, having a carbon-doped charge layer and wherein the diffusion of the P-type doping material in a window layer which is performed in such a manner that P-type dopants are substantially concentrated in a limited zone in the vicinity of the junction and underneath a bias electrode to which a voltage bias is applied in order to generate an electric field.

By using Carbon atoms as dopant of the charge layer instead of Zinc or Beryllium atoms, the out-diffusion of these atoms during the Zinc diffusion in the widow layer is substantially avoided. This is because the Carbon atoms show less diffusivity as compared to Zinc or Beryllium atoms and therefore their expansion out of the charge layer is negligible or substantially lower than the latter atoms. Therefore, the electric field is substantially controlled from being present in undesired zones such as the absorption layer.

Furthermore, by having the dopants concentrated in the limited zone in the vicinity of the junction and under the bias electrode, the electric field is also substantially concentrated in the zone where the dopants are present and thus it is impeded from being dispersed to the outer, or lateral zones of the window layer. As a result leakage currents are avoided or substantially reduced.

Therefore, the above combination of effects contributes to an improved control on the electric field within the device.

In order to achieve this objective, the APD of the present invention is based on a planar junction structure having a stable Carbon p-doped charge layer and a localized P-type doped zone in the vicinity of the junction is so as to concentrate the electric field along the structure of the device. In other words, the electric field is concentrated in a limited section, the absorption layer which is the zone of photogeneration is substantially free of electric field at the surface and the multiplication layer is subjected to a concentrated electric field in a corresponding limited section. Therefore the avalanche process will take place preferably in said limited section of the multiplication layer where a large electric field is concentrated. The electric field at the periphery, *i.e,* out of the limited section of the multiplication layer is then reduced compared to a Mesa-type APD, thus eliminating the APD edge-breakdown and reducing surface dark current.

Accordingly it is an object of the present invention to provide a method of manufacturing a planar junction, separate absorption, grading and multiplication avalanche photodiode comprising an absorption layer and a multiplication layer, wherein the photodiode comprises a charge layer doped with Carbon and an N-type window layer doped with a P-type dopant and being in contact with a bias electrode to which bias voltage is applied so as to generate an electric field in the photodiode, and wherein the doping of the window layer with a P-type dopant is performed by local diffusion of dopant atoms within a limited volume of the window layer adjacent and underneath the bias electrode and wherein the window layer is substantially free of dopant atoms outside said limited volume.

According to an embodiment, the P-type dopant is Zinc or Beryllium.

According to another embodiment, the method further comprises the step of disposing a dielectric window on the window layer so as to limit an exposure area of the window layer used for diffusing the P-type dopants in the limited volume of the window layer.

According to a further embodiment the window layer is of InP material, the absorption layer is of InGaAs, the multiplication is of InGaAlAs lattice matched to InP. A preferred composition for the InGaAlAs multiplication layer is InAlAs.

According to still another embodiment the concentration of Carbon atoms in the charge layer is about 10¹² atoms per cm².

Another object of the present invention is that of providing a planar junction, separate absorption, grading and multiplication avalanche photodiode comprising an absorption layer and a multiplication layer, a charge layer doped with Carbon and an N-type window layer doped with a P-type dopant and being in contact with a bias electrode for receiving a bias voltage so as to generate an electric field in the photodiode, wherein the P-type dopant in the window layer is substantially concentrated within a limited volume of the window layer adjacent and underneath the bias electrode and wherein the window layer is substantially free of dopant atoms outside said limited volume.

According to an embodiment, the P-type dopant is Zinc or Beryllium.

According to another embodiment, a dielectric window is disposed on the window layer thus limiting an exposure area of the window layer for diffusing the P-type dopants in the limited volume of the window layer.

According to a further embodiment the window layer is of InP material, the absorption layer is of InGaAs, the multiplication is of InGaAlAs lattice matched to InP. A preferred composition for the InGaAlAs multiplication layer is InAlAs.

According to still another embodiment the concentration of Carbon atoms in the charge layer is about 10¹² atoms per cm².

These and further features and advantages of the present invention are described in more detail in the following description as well as in the claims with the aid of the accompanying drawings.

### BRIEF DESCRIPTION OF THE DRAWINGS

Figure 1, already discussed, shows a schematic cross section view of a photodiode having SAGM, InAlAs/InGaAs structure in a conventional configuration.
Figure 2, already discussed shows a graph representing Zinc concentration as a function of thickness of the photodiode of figure 1 before and after Zinc diffusion in the window layer.
Figure 3, already discussed, shows a variation of the electric field E.F. in kV/cm as a function of thickness T in microns for the photodiode of figure 1.
Figure 4 shows a schematic cross section view of a photodiode according to the invention.
Figure 5 shows a graph representing Zinc concentration as a function of thickness of a photodiode according to the invention before and after Zinc diffusion in the window layer.
Figure 6 shows a variation of the electric field E.F. in kV/cm as a function of thickness T in microns for a photodiode according to the invention.

### DESCRIPTION OF A PREFERRED EMBODIMENT

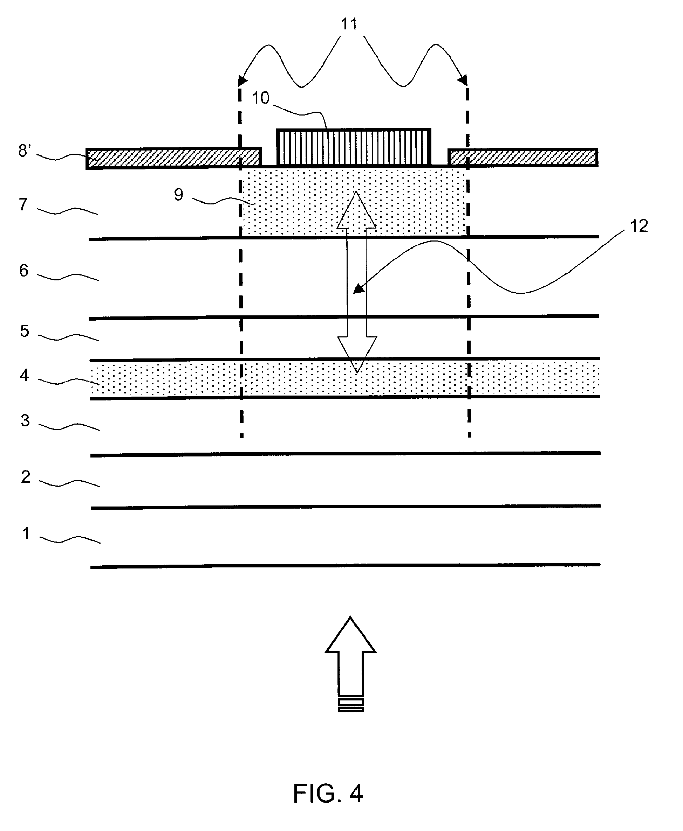

Referring now to figure 4, there is shown a schematic cross section of a photodiode of the type SAGM InGaAlAs/InGaAs according to the invention. In this figure, like elements have like reference numeral as those of figure 1. Here again, light is represented to be incident onto the lower part of the device as shown by an arrow in the figure. This is only exemplary, as light may also be incident to the upper side of the device. Starting from the bottom to the top of the device, in the direction of the entry of photons, the APD of figure 4 comprises:
- a substrate 1, typically made of InP,
- a contact layer 2, usually being N-type and typically of InAlAs material,
- a multiplication layer 3 typically being of non-intentionally doped InGaAlAs lattice matched to InP for which InAlAs is the preferred composition,
- a charge layer 4 typically of InGaAlAs material doped with carbon atoms,
- a grading layer 5 typically of InGaAIAs material,
- an absorption layer 6 typically of non-doped InGaAs material,
- a window layer 7 typically of InP N-type material intentionally non-doped, inside of which a P-type doped zone 9 is provided typically by diffusion of Zinc.

The device is then covered with a passivation layer 8' acting as a protection layer of the semiconductor surface to reduce surface recombination current and to improve device long term reliability, the layer being of dielectric material which serves also as a masking shield for the diffusion of the Zinc as will be described. A bias electrode 10 is disposed on the window layer in an opening (window) in the passivation layer 8'.

The above layers may be made by known techniques such as expitaxial methods or others known to a person skilled in the art.

The concentration rate of Carbon atoms in the charge layer is preferably about 10¹² atoms per cm².

As previously mentioned, the use of carbon in the charge layer allows for the elimination or substantially reduction of the out-diffusion effect. This improvement is represented in figure 4 where it is appreciated that the Carbon atoms, represented by dots in the figure, are confined in the charge layer 4 and have not extended outside this layer.

The process of Zinc diffusion into the window layer 7 photodiode is performed in such a manner that Zinc atoms are introduced into the bulk of the window layer 7 only within a limited volume of this layer. In order to achieve this objective, the window layer is covered with a passivation layer 8'. This layer is deposited on the window layer 7. Next an opening (or window) is made in a predetermined area on the surface of the window layer 7. This operation may be performed by known techniques such as for example photolithography followed by dry or wet chemical etching of the passivation layer 8'. The opening, or window, is represented in figure 4 by the open zone between the two covering portions of the passivation layer 8' on top of the window layer 7 where the bias electrode 10 is located (it is understood that the bias electrode is placed in position after the diffusion is performed and not before it). The passivation layer 8' therefore acts as a mask for the process of Zinc diffusion by only allowing the entry of Zinc atoms through the said window. In this manner, Zinc atoms penetrate inside the bulk of the window layer only through the opening and are therefore diffused in the window layer substantially in the vicinity of said window. This is represented in figure 4 by means of a dotted zone 9. As seen in the figure, the Zinc atoms are substantially distributed in the bulk of the window layer 7 in the vicinity of the window, leaving the rest of the volume of the window layer substantially free of Zinc atoms.

The diffusion process can be performed using semi-sealed ampoule technique with ZnAs2 dopant source or in a Metal-organic vapor phase epitaxy (MOVPE) reactor using DiEthyl-Zinc DEZn (precursor) or using Be dopant in an Molecular Beam Epitaxy (MBE) machine. These techniques are known in the related art. The main parameters of such process are diffusion temperature, diffusion time, precursor concentration, etc. Usually, a calibration of the diffusion process is necessary to adjust diffusion depth, shape and doping level,...

Finally the bias electrode 10 is placed on the window layer just above the zone where the Zinc atoms are diffused.

With this configuration, when a bias voltage is applied to the bias electrode 10 in order to generate an electrical field within the APD, the concentration of Zinc atoms, mainly underneath the bias electrode allows to confine the electric field in a limited, desired, zone and to avoid its presence out of such limited zone. The absence of electric field outside the boundaries of the limited zone has the consequence that charge carriers outside the limited zone are not affected by an electric field and thus do not generate an unwanted current such as a leakage current. The limited zone where the electric field is mainly present is represented in figure 4 by means of broken lines 11 and the electric field itself is represented by the arrow 12.

This effect, namely confining the electric field in a limited and thus controlled zone, together with the effect of a stable C-doped charge layer after Zn-diffusion reduces the undesired effect of leakage currents and thus allows for obtaining a high electric field in the multiplication layer while the electric field in the absorption layer remains low thus favoring a high multiplication gain without excessive dark current as the maximum electric field in the multiplication layer is concentrated in a limited section of the multiplication volume and out-diffusion is absent in the charge layer.

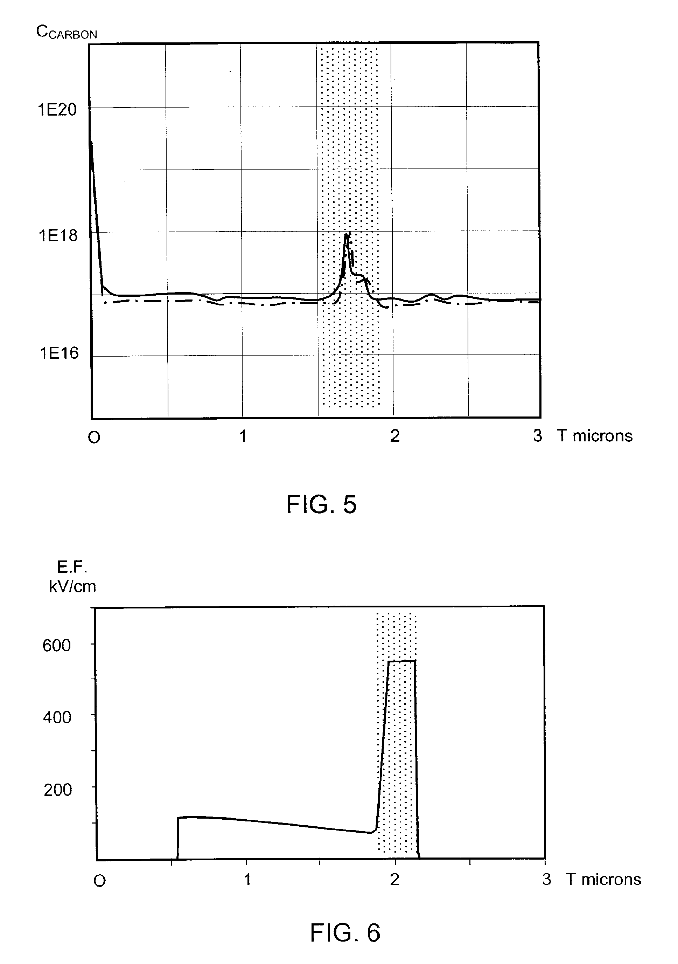

Figure 5 shows the concentration rate of Carbon atoms C_{CARBON} in number of atoms per cm³ as a function of thickness T in microns. The solid line curve shows the concentration before the diffusion of the dopant in the window layer 7 and the broken line shows this concentration after the diffusion of Zinc is performed in the window layer in a controlled manner according to the invention.

Here again, the measurements are made by the technique known as Secondary Ion Mass Spectrometry (SIMS). In the figure, the charge layer zone is represented by a dotted zone.

It is observed from the figure that the concentration of the Carbon atoms is substantially stable and remains within the charge layer after the dopant diffusion is done in the window layer.

As discussed above, this effect has as a consequence, a substantial decrease in the electric field in the absorption layer. Figure 6 represents this consequence. In this figure, the variation of the electric field E.F. is shown in kV/cm as a function of thickness T in microns. The multiplication layer is shown by a dotted zone. It is observed that the electric field in the multiplication layer is about six times higher than the electric field in the absorption layer. The reduced electric field in the absorption layer reduces substantially the generation of dark currents associated in particular to tunneling effect generally observed in low band-gap material like InGaAs under high applied electric field.

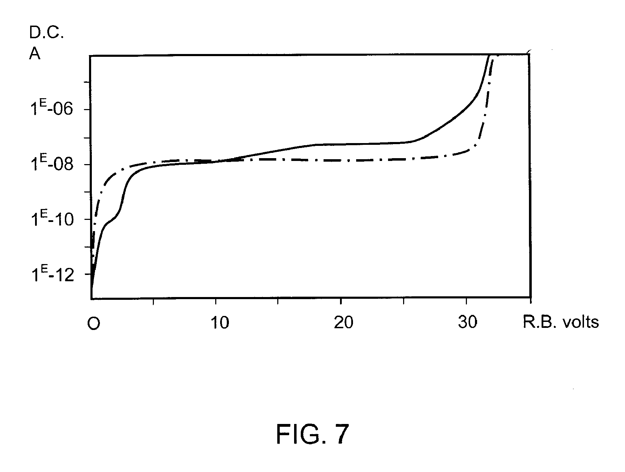

Figure 7 shows this effect. In this figure, the variation of dark current D.C. is represented in Amperes as a function of reverse biased voltage across two photodiodes in volts after diffusion. One of said photodiode is structured in a conventional manner, namely has a Zinc-doped charge layer APD and non-localized dispersion of Zinc atoms in the contact layer and the other APD is structured according to the present invention. The solid line in figure 7 corresponds to the conventional APD, and the broken line corresponds to the APD according to the invention. The figure clearly shows the improved performance obtained by the APD manufactured according to the present invention where dark current at high operating bias voltage, which is where the avalanche multiplication occurs is substantially lower than that of the conventional APDs.

The solution of the present invention therefore provides the possibility of obtaining an APD with low dark current, high reliability and better dynamic performances as is increasingly needed for applications at 10Gbit/s rates or even higher.

## Claims

1. A method of manufacturing a planar junction, separate absorption, grading and multiplication avalanche photodiode comprising an absorption layer and a multiplication layer, wherein the photodiode comprises a charge layer doped with Carbon and an N-type window layer doped with a P-type dopant and being in contact with a bias electrode to which bias voltage is applied so as to generate an electric field in the photodiode, and wherein the doping of the window layer with a P-type dopant is performed by local diffusion of dopant atoms within a limited volume of the window layer adjacent and underneath the bias electrode and wherein the window layer is substantially free of dopant atoms outside said limited volume.

2. The method of claim 1, wherein the P-type dopant is Zinc or Beryllium.

3. The method of claim 1 or claim 2, wherein the method further comprises the step of disposing a dielectric window on the window layer so as to limit an exposure area of the window layer used for diffusing the P-type dopants in the limited volume of the window layer.

4. The method of any one of the previous claims, wherein the window layer is of InP material, the absorption layer is of InGaAs, the multiplication is of InGaAlAs lattice matched to InP.

5. The method of claim 4 wherein the composition for the InGaAlAs multiplication layer is InAlAs.

6. The method of any one of the previous claims, wherein the concentration of Carbon atoms in the InGaAlAs charge layer is about 10¹² atoms per cm².

7. A planar junction, separate absorption, grading and multiplication avalanche photodiode comprising an absorption layer and a multiplication layer, a charge layer doped with Carbon and an N-type window layer doped with a P-type dopant and being in contact with a bias electrode for receiving a bias voltage so as to generate an electric field in the photodiode, wherein the P-type dopant in the window layer is substantially concentrated within a limited volume of the window layer adjacent and underneath the bias electrode and wherein the window layer is substantially free of dopant atoms outside said limited volume.

8. The photodiode of claim 7, wherein the P-type dopant is Zinc or Beryllium.

9. The photodiode of claim 7 or 8, wherein a dielectric window is disposed on the window layer thus limiting an exposure area of the window layer for diffusing the P-type dopants in the limited volume of the window layer.

10. The photodiode of any one of claims 7 to 9, wherein the window layer is of InP material, the absorption layer is of InGaAs, the multiplication is of InGaAlAs lattice matched to InP.

11. The method of claim 10 where in the composition for the InGaAlAs multiplication layer is InAlAs.

12. The photodiode of any one of claims 7 to 11, wherein the concentration of Carbon atoms in the InGaAlAs charge layer is about 10¹² atoms per cm².
